# EUROPEAN PATENT APPLICATION

(11) **EP 4 780 186 A1**
(43) Date of publication of application: **22.07.2026**
(21) Application number: 26150907.9
(22) Date of filing: 08.01.2026
(51) Int. Cl.: H10N 60/01, H10N 60/80, H10N 69/00

(54) **JOSEPHSON PARAMETRIC AMPLIFIER AND METHOD OF MANUFACTURING JOSEPHSON PARAMETRIC AMPLIFIER**

(30) Priority: 15.01.2025 JP 2025005294
(71) Applicant: Fujitsu Limited, Kawasaki-shi, Kanagawa 211-8588 (JP)
(72) Inventor: HIROSE, Shinichi, Kawasaki-shi, 211-8588 (JP); KOUMA, Norinao, Kawasaki-shi, 211-8588 (JP); DAISUKE, Saida, Kawasaki-shi, 211-8588 (JP); HIROYASU, Kawano, Kawasaki-shi, 211-8588 (JP)
(74) Representative: Haseltine Lake Kempner LLP

(57) **Abstract**

A Josephson parametric amplifier (10) includes: a substrate (15); a superconducting quantum interference device (21) that includes a Josephson junction provided on the substrate; a ring-shaped structure (40) that is configured by a superconductor and that is provided so as to cover the superconducting quantum interference device; and a magnetic flux generating portion that generates magnetic flux passing through a ring inner side of the ring-shaped structure.

## Description

### FIELD

The technology of the disclosure relates to a Josephson parametric amplifier, a method of manufacturing a Josephson parametric amplifier, and a method of driving a Josephson parametric amplifier.

### BACKGROUND

The following technology is known as technology relating to an amplifier using a superconducting quantum interference device (SQUID). Patent Document 1 describes a configuration in which a guard ring is provided around a SQUID in a material testing device including a detection circuit that includes a magnetic sensor using a SQUID, and a signal processing circuit that processes a signal output from the detection circuit.

Patent Document 2 describes a traveling wave parametric amplifier including a coplanar waveguide that includes at least one Josephson junction device that interrupts a central trace of the coplanar waveguide, and at least one shunt capacitor that is coupled to the coplanar waveguide. A first plate of the capacitor is formed by a central trace of the coplanar waveguide, and a second plate of the capacitor is formed by a conductive trace forming an air-bridge structure.

Patent Document 3 describes a parametric amplifier that includes an LC resonator including a DC SQUID configured by arranging Josephson junctions in parallel, and a DC magnetic flux bias line, and that magnetic flux biases the DC SQUID using the DC magnetic flux bias line.

### Related Patent Documents

Patent Document 1: Japanese Patent Application Laid-Open (JP-A) No. H08-211022
Patent Document 2: Japanese Patent Application Laid-Open (JP-A) No. 2022-543639
Patent Document 3: Japanese Patent Application Laid-Open (JP-A) No. 2009-225213

Integration of superconducting quantum bits has been actively promoted with the aim of realizing a quantum computer. One important research topic in the integration of superconducting quantum bits is how quickly and efficiently the quantum bits are read. A technique called "distributed reading" is used to read superconducting quantum bits. In distributed reading, rather than reading the quantum bit directly, the reading is performed via the response of a resonator coupled to the quantum bit. The resonance frequency of the resonator is shifted (dispersion shifted) in accordance with the state of the quantum bit. The state of the quantum bit can be understood by irradiating with microwaves and observing the shift amount of the resonance frequency. Since the level of a signal used for distributed reading is weak, it is necessary to amplify the signal using a low noise amplifier. A superconducting amplifier, which is referred to as a Josephson parametric amplifier (JPA), is used in such applications.

A superconducting quantum interference device (SQUID), which is a main part of a Josephson parametric amplifier (JPA), forms a closed loop of superconductivity. The amount of magnetic flux trapped inside the loop is quantized by the shielding current flowing through the closed loop. In order to drive the JPA, it is necessary to continuously apply magnetic flux that penetrates inside the loop of the SQUID. In other words, during operation of a quantum computer, it is necessary to continuously supply power to the inductor, which serves as a supply source of magnetic flux to the SQUID. The thermal noise generated accompanying power supply to the inductor causes the read fidelity of the quantum bit to be reduced.

### SUMMARY

It is desirable for the technology of the disclosure to suppress, in a Josephson parametric amplifier (JPA) including a superconducting quantum interference device (SQUID), thermal noise caused by a supply source of magnetic flux to the SQUID.

A Josephson parametric amplifier according to the technology of the disclosure includes: a substrate; a superconducting quantum interference device that includes a Josephson junction provided on the substrate; a ring-shaped structure that is configured by a superconductor and that is provided so as to cover the superconducting quantum interference device; and a magnetic flux generating portion that generates magnetic flux passing through a ring inner side of the ring-shaped structure.

### BRIEF DESCRIPTION OF THE DRAWINGS

Reference will now be made, by way of example only, to the following drawings, in which:
Fig. 1 is an equivalent circuit diagram illustrating an example of a configuration of a Josephson parametric amplifier according to an exemplary embodiment of the technology of the disclosure.
Fig. 2 is a diagram schematically illustrating a state in which magnetic flux is applied to a SQUID using a magnetic flux generating portion and a ring-shaped structure according to an exemplary embodiment of the technology of the disclosure.
Fig. 3 is a diagram schematically illustrating a state in which magnetic flux is applied to a SQUID without using a ring-shaped structure.
Fig. 4 is a top view illustrating an example of a configuration around a SQUID and a ring-shaped structure according to an exemplary embodiment of the technology of the disclosure.
Fig. 5A is a cross-sectional view taken along line 5A-5A in Fig. 4.
Fig. 5B is a cross-sectional view taken along line 5B-5B in Fig. 4.
Fig. 5C is a cross-sectional view taken along line 5C-5C in Fig. 4.
Fig. 6A is a cross-sectional view illustrating an example of a method of manufacturing a Josephson parametric amplifier according to an exemplary embodiment of the technology of the disclosure.
Fig. 6B is a cross-sectional view illustrating an example of a method of manufacturing a Josephson parametric amplifier according to an exemplary embodiment of the technology of the disclosure.
Fig. 6C is a cross-sectional view illustrating an example of a method of manufacturing a Josephson parametric amplifier according to an exemplary embodiment of the technology of the disclosure.
Fig. 6D is a cross-sectional view illustrating an example of a method of manufacturing a Josephson parametric amplifier according to an exemplary embodiment of the technology of the disclosure.
Fig. 6E is a cross-sectional view illustrating an example of a method of manufacturing a Josephson parametric amplifier according to an exemplary embodiment of the technology of the disclosure.
Fig. 6F is a cross-sectional view illustrating an example of a method of manufacturing a Josephson parametric amplifier according to an exemplary embodiment of the technology of the disclosure.
Fig. 7 is a top view illustrating an example of a method of manufacturing a Josephson parametric amplifier according to an exemplary embodiment of the technology of the disclosure.
Fig. 8 is a cross-sectional view illustrating an example of a configuration of a Josephson parametric amplifier according to another exemplary embodiment of the technology of the disclosure.

### DESCRIPTION OF EMBODIMENTS

Explanation follows regarding an example of an exemplary embodiment of the technology of the disclosure, with reference to the drawings. Note that the same reference numerals are allocated to the same or equivalent components and portions in the drawings, and duplicate explanation thereof is omitted.

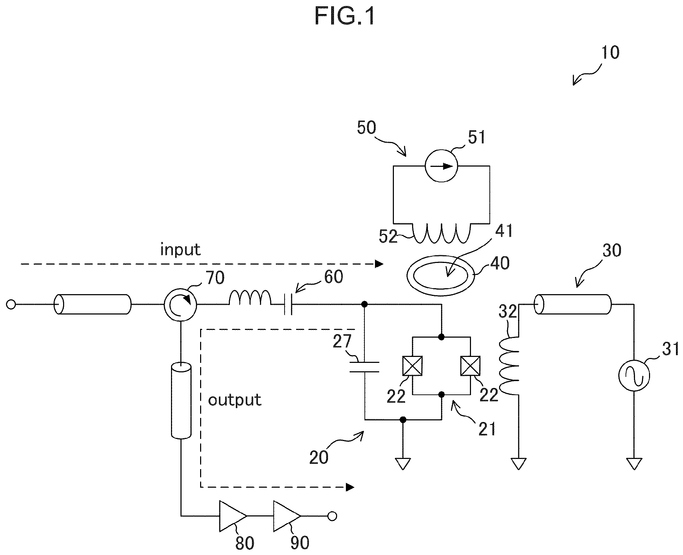

Fig. 1 is an equivalent circuit diagram illustrating an example of a configuration of a Josephson parametric amplifier (hereinafter referred to as JPA) 10 according to an exemplary embodiment of the technology of the disclosure. The JPA 10 is used in an extremely low temperature environment (for example, about 10 mK) together with a superconducting quantum bit that is not illustrated in the drawings.

The JPA 10 includes a JPA resonator 20, a pump signal generating portion 30, a ring-shaped structure 40, a magnetic flux generating portion 50, an impedance matching circuit 60, a circulator 70, a high electron mobility transistor (HEMT) 80, and a low noise amplifier 90.

The impedance matching circuit 60 includes an inductor component and a capacitor component, and is disposed on a path of a signal. The reflection of a signal is suppressed by the impedance matching circuit 60, enabling the signal transmission efficiency between the quantum bit serving as a signal source and the JPA resonator 20 to be maximized. Moreover, the performance in a specific frequency band can be optimized, enabling the operating range of the JPA resonator 20 to be widened.

The circulator 70 is used in order to ensure the unidirectional nature of signals. Namely, the circulator 70 separates the signal read from the quantum bit and the signal amplified by the JPA resonator 20. This prevents the input signal and the amplified signal from interfering with each other. Fig. 1 illustrates an input path and an output path of a signal by broken line arrows.

The JPA resonator 20 includes a superconducting quantum interference device (hereinafter referred to as SQUID) 21 and a capacitor 27 that is connected in parallel to the SQUID 21. The SQUID 21 includes two Josephson junctions 22 within the circumference of a ring configured by a superconductor. As the magnetic flux passing through the ring changes, the tunneling current flowing through the Josephson junctions 22 changes by an integer multiple of the flux quantum. This property enables the SQUID 21 to function as a high sensitivity flux meter. The JPA resonator 20 performs signal amplification through a parametric amplification process by temporally modulating an equivalent inductance of the SQUID 21 using a pump signal that is supplied from the pump signal generating portion 30.

The pump signal generating portion 30 generates a pump signal for modulating the non-linear inductance of the SQUID 21. The pump signal generating portion 30 includes a signal source 31 and a waveguide 32 that includes an inductor component. The non-linear inductance, which is a circuit parameter of the SQUID 21, is modulated by a pump signal having a frequency that is twice the resonance frequency, thereby causing parametric amplification in the JPA resonator 20. Parametric amplification enables extremely high sensitivity and low noise signal amplification to be realized.

Adjusting the magnetic flux applied to the SQUID 21 enables the effective inductance of the SQUID 21 to be changed to adjust the resonance frequency of the JPA resonator 20. This enables the operating point of the JPA resonator 20 to be optimized, enabling performance in a specific frequency band to be improved. The magnetic flux is applied to the SQUID 21 by the magnetic flux generating portion 50 and the ring-shaped structure 40.

The ring-shaped structure 40 is a ring-shaped structure configured by a superconductor provided so as to cover the SQUID 21. The magnetic flux cannot penetrate into the superconductor due to the Meissner effect. However, the magnetic flux can pass through an opening (hole) 41 at a ring inner side of the ring-shaped structure 40 configured by a superconductor. The magnetic flux passing through the opening 41 of the ring-shaped structure 40 is an integer multiple of the flux quantum, and is held at the ring inner side. The flux quantum held at the ring inner side acts as a superconducting electromagnet.

The magnetic flux generating portion 50 generates magnetic flux that passes through the opening 41 of the ring-shaped structure 40. The magnetic flux generating portion 50 includes an inductor 52 and a current source 51. The inductor 52 is typically a direct current coil. The current supplied from the current source 51 flows through the inductor 52 to generate magnetic flux, and this magnetic flux passes through the opening 41 of the ring-shaped structure 40. A voltage source may be used in place of the current source 51.

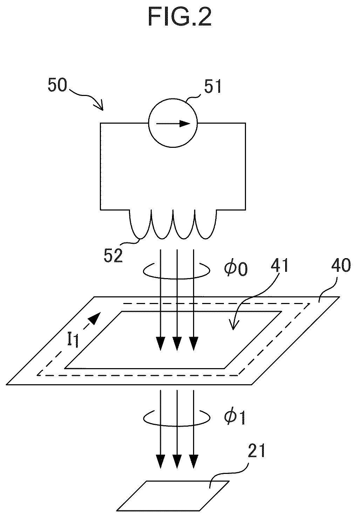

Fig. 2 is a diagram schematically illustrating an aspect in which magnetic flux is applied to the SQUID 21 using the magnetic flux generating portion 50 and the ring-shaped structure 40. The magnetic flux Φ₀ generated by the magnetic flux generating portion 50, in a state in which the ring-shaped structure 40 configured by a superconductor is exhibiting a superconducting state, passes through the opening 41 of the ring-shaped structure 40, so that an induced current I₁ flows through the ring-shaped structure 40. Since the superconductor has zero electrical resistance, the induced current I₁ becomes a permanent current, and the ring-shaped structure 40 continuously generates a DC magnetic flux Φ₁. As a result, the ring-shaped structure 40 behaves as a static magnet, and continuously and stably supplies the magnetic flux Φ₁ to the SQUID 21.

As long as the superconducting state of the ring-shaped structure 40 is not broken, the flux quantum at the ring inner side is not attenuated. Namely, the behavior of the ring-shaped structure 40 as a static magnet is permanent at extremely low temperatures. After the magnetic flux is held at the ring inner side of the ring-shaped structure 40, the behavior of the ring-shaped structure 40 as a static magnet continues even if the supply of the magnetic flux φ₀ from the magnetic flux generating portion 50 is stopped.

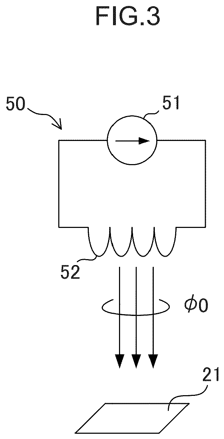

On the other hand, as illustrated in Fig. 3, in a case in which the ring-shaped structure 40 is not present, during operation of the quantum bit, it is necessary for the magnetic flux generating portion 50 to continuously supply the magnetic flux φ₀ to the SQUID 21. In this case, power supply to the inductor 52 is continuously performed. The thermal noise generated accompanying power supply to the inductor causes the read fidelity of the quantum bit in the JPA 10 to be reduced. Moreover, power consumption becomes enormous.

As illustrated in Fig. 2, by supplying magnetic flux to the SQUID 21 via the ring-shaped structure 40, power supply to the inductor 52 is not required after the magnetic flux is held at the ring inner side of the ring-shaped structure 40, enabling the problems of thermal noise and power consumption to be solved.

The signal amplified by the JPA resonator 20 is amplified by the HEMT 80 and again amplified by the low noise amplifier 90 placed at room temperature. Since the HEMT 80 operates in a wide band, the signal amplified by the JPA resonator 20 can be efficiently processed over a wide frequency range. The combination of the JPA resonator 20 and the HEMT 80 is extremely effective in enabling both high sensitivity amplification of signals and low noise characteristics to be achieved. The output signal of the low noise amplifier 90 is detected by a network analyzer that is not illustrated in the drawings.

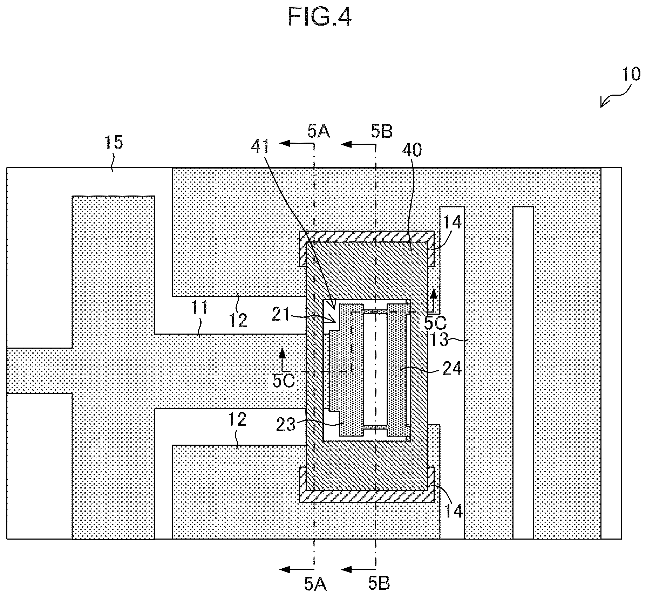

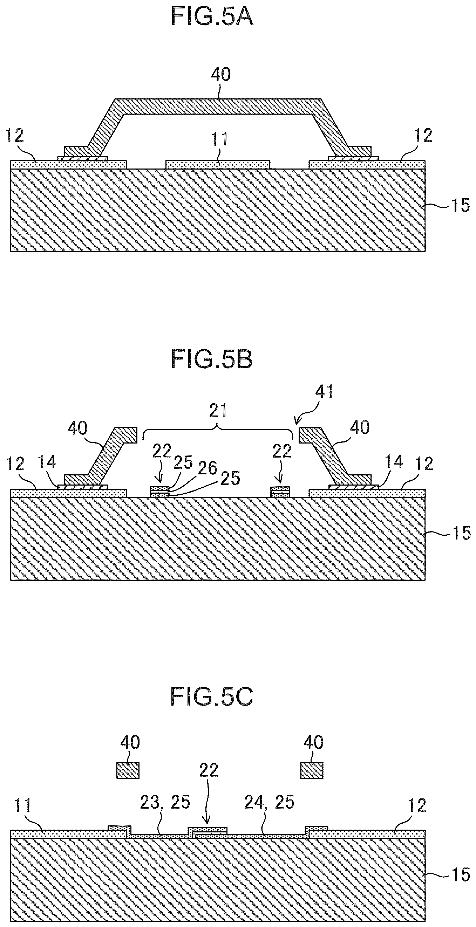

Fig. 4 is a top view illustrating an example of a configuration around the SQUID 21 and the ring-shaped structure 40. Fig. 5A, Fig. 5B, and Fig. 5C are cross-sectional views taken along lines 5A-5A, lines 5B-5B, and lines 5C-5C in Fig. 4, respectively.

The SQUID 21 and the ring-shaped structure 40 are provided on a substrate 15. For example, a silicon substrate can be used as the substrate 15. The two Josephson junctions 22 configuring the SQUID 21 each include two superconductor layers 25 and an ultrathin insulator layer 26 that has a thickness of approximately several nm and that is sandwiched between the two superconductor layers 25. Aluminum (Al), for example, can be used as a material for the superconductor layers 25, and aluminum oxide (Al₂O₃), for example, can be used as a material for the insulator layer 26. One of the superconductor layers 25 also functions as a signal electrode 23, and another of the superconductor layers 25 also functions as a ground electrode 24. The superconductor layers 25 are patterned in a ring shape including the two Josephson junctions 22 within the circumference thereof, thereby forming the SQUID 21.

A signal waveguide 11 and a ground plane 12, which are configured by a superconductor, are provided on the substrate 15. The signal electrode 23 of the SQUID 21 is connected to the signal waveguide 11, and the ground electrode 24 of the SQUID 21 is connected to the ground plane 12. For example, niobium (Nb) can be used as a superconductor that configures the signal waveguide 11 and the ground plane 12. The ground plane 12 is provided at both sides of the SQUID 21 up and down (or left and right) so as to sandwich the SQUID 21 therebetween.

The ring-shaped structure 40 is provided so as to cover the SQUID 21. As illustrated in Fig. 4, the opening 41 of the ring-shaped structure 40 is arranged at a position that overlaps with the SQUID 21 in plan view. The ring-shaped structure 40 has a bridge structure that straddles the SQUID 21. The ring-shaped structure 40 includes two bridge column portions connected to the ground plane 12, via an insulator film 14, at both sides sandwiching the SQUID 21, and an arch portion that passes over the SQUID 21 and connects the two bridge column portions. Aluminum (Al), for example, can be used as a superconductor configuring the ring-shaped structure 40. The insulator film 14 is provided at a connection portion with the ring-shaped structure 40 on both sides of the ground plane 12 sandwiching the SQUID 21 therebetween. A silicon nitride film (Si₃N₄) can be used as the insulator film 14.

As illustrated in Fig. 4, a waveguide 13 of the pump signal generated by the pump signal generating portion 30 is drawn out to a position near the SQUID 21 on the substrate 15, and an end of the waveguide 13 is connected to the ground plane 12.

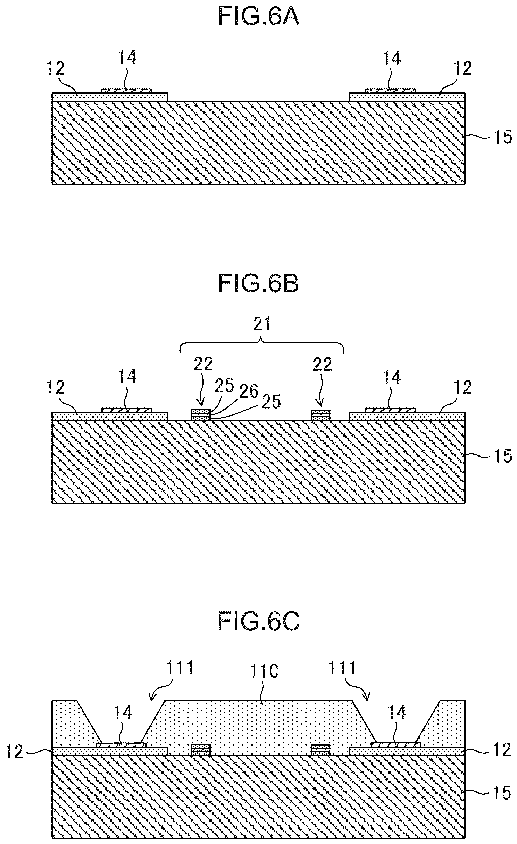

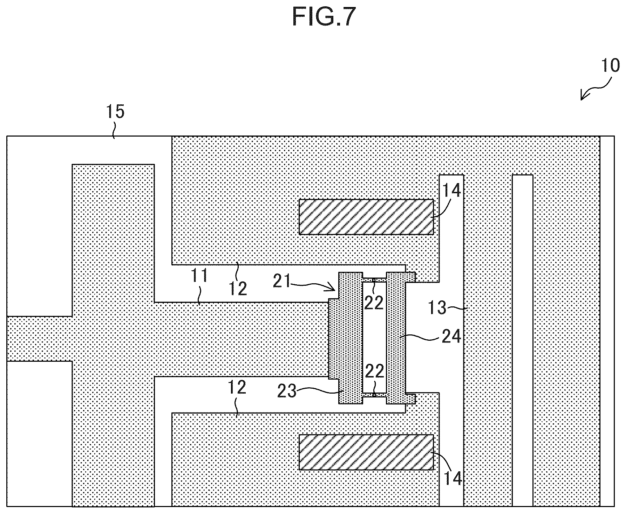

Explanation follows regarding a method of manufacturing the JPA 10, with reference to Fig. 6A to Fig. 6F and Fig. 7. First, a superconducting metal film that configures the signal waveguide 11 and the ground plane 12 is formed on the surface of the substrate 15 using a film deposition technique such as a sputtering method. A silicon substrate, for example, can be used as the substrate 15, and niobium (Nb) can be used as a material for the superconducting metal film.

Next, the insulator film 14 is formed on the surface of the superconducting metal film by a film deposition technique such as plasma chemical vapor deposition (CVD). A silicon nitride film (Si₃N₄), for example, can be used as a material for the insulator film 14. Next, the insulator film 14 is patterned by photolithography and wet etching. The insulator film 14 is removed, except for the portions connected to the ring-shaped structure 40.

Next, the superconducting metal film is patterned by photolithography and dry etching. This forms the signal waveguide 11, the ground plane 12, the waveguide 13 of the pump signal, and the like on the substrate 15 (Fig. 6A).

Next, the SQUID 21 is formed on the surface of the substrate 15. Specifically, a resist mask (not illustrated in the drawings) for forming a pattern of the SQUID 21 by lift-off is formed on the surface of the substrate 15. Next, the superconductor layer 25, the insulator layer 26, and the superconductor layer 25 are sequentially formed using a film deposition technique such as electron beam deposition. Aluminum (Al), for example, can be used as a material for the superconductor layers 25, and aluminum oxide (Al₂O₃), for example, can be used as a material for the insulator layer 26. Next, the excess of the superconductor layers 25 is removed together with the resist mask. The superconductor layers 25 are patterned in a ring shape including the two Josephson junctions 22 within the circumference thereof to thereby form the SQUID 21 (Fig. 6B). The signal electrode 23 and the ground electrode 24 are formed by patterning the superconductor layer 25. Fig. 7 is a top view of the JPA 10 at this stage.

Next, a resist mask 110 is formed on the surface of the substrate 15 in order to form a bridge structure of the ring-shaped structure 40. The resist mask 110 includes an opening 111 that exposes a surface of the insulator layer 26 (Fig. 6C).

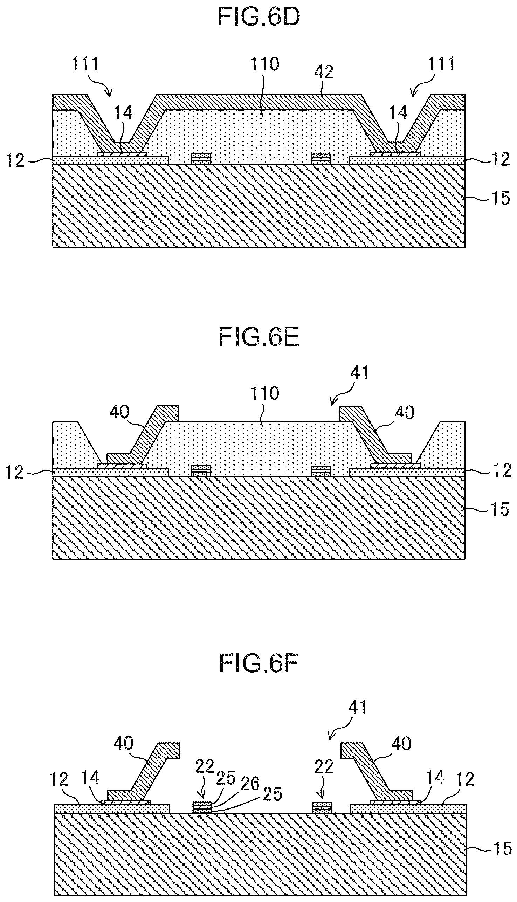

Next, a superconductor film 42 that configures the ring-shaped structure 40 is formed so as to cover the surface of the resist mask 110 using a film deposition technique such as electron beam deposition. The superconductor film 42 covers the entire surface of the resist mask 110, and is connected to the insulator film 14 that is exposed at the opening 111 of the resist mask 110 (Fig. 6D).

Next, the superconductor film 42 is patterned by photolithography and etching. This forms the ring-shaped structure 40 having the opening 41 at the center (Fig. 6E).

Next, the resist mask 110 is removed using an organic solvent. This forms a bridge structure of the ring-shaped structure 40 (Fig. 6F). Next, the magnetic flux generating portion 50 is disposed at a position aligned with the substrate 15. Namely, the magnetic flux generating portion 50 and the substrate 15 are aligned so that the magnetic flux φ₀ generated by the magnetic flux generating portion 50 passes through the ring inner side of the ring-shaped structure 40.

As described above, the JPA 10 according to the exemplary embodiment of the technology of the disclosure includes the substrate 15, the SQUID 21 having a Josephson junction provided on the substrate 15, the ring-shaped structure 40 configured by a superconductor provided so as to cover the SQUID 21, and the magnetic flux generating portion 50 that generates magnetic flux passing through the ring inner side of the ring-shaped structure 40. The ring-shaped structure 40 has an opening 41 at a position that overlaps with the SQUID 21 in plan view. The ring-shaped structure 40 has a bridge structure that straddles the SQUID 21.

The method of driving the JPA 10 according to the technology of the disclosure includes: providing the ring-shaped structure 40, which is configured by a superconductor, so as to cover the SQUID 21 that includes a Josephson junction provided on the substrate 15; in a state in which the ring-shaped structure 40 exhibits a superconducting state, supplying magnetic flux Φ₀, from the magnetic flux generating portion 50, which passes through the ring inner side of the ring-shaped structure 40 to generate an induced current I₁ that flows through the ring-shaped structure 40; and in a state in which the ring-shaped structure 40 exhibits a superconducting state, stopping supply of the magnetic flux Φ₀, from the magnetic flux generating portion 50, after generating the induced current I₁.

In the JPA 10 according to the exemplary embodiment of the technology of the disclosure, the magnetic flux Φ₀ generated by the magnetic flux generating portion 50 passes through the opening 41 of the ring-shaped structure 40 configured by a superconductor, so that a permanent current circulating through the ring-shaped path flows inside the ring-shaped structure 40. As a result, the ring-shaped structure 40 behaves as a static magnet, and continuously and stably supplies the magnetic flux Φ₁ to the SQUID 21. The behavior of the ring-shaped structure 40 as a static magnet is permanent as long as the superconducting state of the ring-shaped structure 40 is maintained. Namely, after the magnetic flux is held at the ring inner side of the ring-shaped structure 40, the behavior of the ring-shaped structure 40 as a static magnet continues even if the supply of the magnetic flux Φ₀ from the magnetic flux generating portion 50 is stopped. Therefore, the JPA 10 according to the present exemplary embodiment enables the supply of magnetic flux to the SQUID 21 to be continued without accompanying power consumption. This enables thermal noise caused by the supply source of magnetic flux to the SQUID 21 to be suppressed, and also enables power consumption to be suppressed.

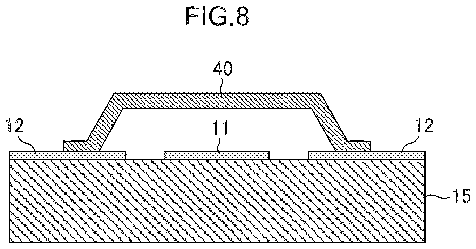

Note that although a configuration in which the ring-shaped structure 40 is connected to the ground plane 12 via the insulator film 14 has been exemplified in the above explanation, as illustrated in Fig. 8, the ring-shaped structure 40 may be directly connected to the ground plane 12. When a potential difference is present between the ground planes 12 that face each other with the SQUID 21 interposed therebetween, there is a possibility that the characteristics of the JPA 10 will change. By the ring-shaped structure 40 being directly connected to the ground plane 12, the ground planes 12 that face each other with the SQUID 21 interposed therebetween are electrically connected via the ring-shaped structure 40. This enables the potential difference between the ground planes 12 to be reduced, enabling changes in the characteristics of the JPA 10 to be suppressed.

According to the technology of the disclosure, it is possible to suppress, in a Josephson parametric amplifier (JPA) including a superconducting quantum interference device (SQUID), thermal noise caused by a supply source of magnetic flux to the SQUID.

With regard to the above-described exemplary embodiments, the following additional notes are disclosed.

### Additional Note 1

A Josephson parametric amplifier includes: a substrate; a superconducting quantum interference device that includes a Josephson junction provided on the substrate; a ring-shaped structure that is configured by a superconductor and that is provided so as to cover the superconducting quantum interference device; and a magnetic flux generating portion that generates magnetic flux passing through a ring inner side of the ring-shaped structure.

### Additional Note 2

The Josephson parametric amplifier according to Additional Note 1, wherein the ring-shaped structure has an opening at a position that overlaps with the superconducting quantum interference device in plan view.

### Additional Note 3

The Josephson parametric amplifier according to Additional Note 1 or Additional Note 2, wherein the ring-shaped structure includes a bridge structure that straddles the superconducting quantum interference device.

### Additional Note 4

The Josephson parametric amplifier according to Additional Note 3, wherein: the Josephson parametric amplifier further includes, on the substrate, a ground plane that is configured by a superconductor and that is provided so as to sandwich the superconducting quantum interference device therebetween; and the ring-shaped structure is connected to the ground plane.

### Additional Note 5

The Josephson parametric amplifier according to Additional Note 3, wherein: the Josephson parametric amplifier further includes, on the substrate, a ground plane that is configured by a superconductor and that is provided so as to sandwich the superconducting quantum interference device therebetween; and the ring-shaped structure is connected to the ground plane via an insulator film.

### Additional Note 6

The Josephson parametric amplifier according to any one of Additional Note 1 to Additional Note 5, further including a pump signal generating portion that generates a pump signal for modulating non-linear inductance of the superconducting quantum interference device.

### Additional Note 7

A method of manufacturing a Josephson parametric amplifier, the method including: forming a superconducting quantum interference device that includes a Josephson junction on a substrate; forming a ring-shaped structure, which is configured by a superconductor, so as to cover the superconducting quantum interference device; and disposing a magnetic flux generating portion, which generates magnetic flux passing through a ring inner side of the ring-shaped structure, at a position aligned with the substrate.

### Additional Note 8

The method of manufacturing a Josephson parametric amplifier according to Additional Note 7, wherein the ring-shaped structure has an opening at a position that overlaps with the superconducting quantum interference device in plan view.

### Additional Note 9

The method of manufacturing a Josephson parametric amplifier according to Additional Note 7 or Additional Note 8, wherein the ring-shaped structure includes a bridge structure that straddles the superconducting quantum interference device.

### Additional Note 10

The method of manufacturing a Josephson parametric amplifier according to any one of Additional Note 7 to additional Note 9, wherein: the method further includes forming, on the substrate, a ground plane, which is configured by a superconductor, so as to sandwich the superconducting quantum interference device therebetween; and the ring-shaped structure is connected to the ground plane.

### Additional Note 11

The method of manufacturing a Josephson parametric amplifier according to any one of Additional Note 7 to additional Note 9, wherein: the method further includes forming, on the substrate, a ground plane, which is configured by a superconductor, so as to sandwich the superconducting quantum interference device therebetween; and the ring-shaped structure is connected to the ground plane via an insulator film.

### Additional Note 12

A method of driving a Josephson parametric amplifier, the method including: providing a ring-shaped structure, which is configured by a superconductor, so as to cover a superconducting quantum interference device that includes a Josephson junction provided on a substrate; in a state in which the superconductor of the ring-shaped structure exhibits a superconducting state, supplying magnetic flux passing through a ring inner side of the ring-shaped structure to generate an induced current that flows through the ring-shaped structure; and in a state in which the superconductor of the ring-shaped structure exhibits a superconducting state, stopping supply of the magnetic flux after generating the induced current.

## Claims

1. A Josephson parametric amplifier includes:
a substrate;
a superconducting quantum interference device that includes a Josephson junction provided on the substrate; a ring-shaped structure that is configured by a superconductor and that is provided so as to cover the superconducting quantum interference device; and
a magnetic flux generating portion that generates magnetic flux passing through a ring inner side of the ring-shaped structure.

2. The Josephson parametric amplifier according to claim 1, wherein the ring-shaped structure has an opening at a position that overlaps with the superconducting quantum interference device in plan view.

3. The Josephson parametric amplifier according to claim 1 or claim 2, wherein the ring-shaped structure includes a bridge structure that straddles the superconducting quantum interference device.

4. The Josephson parametric amplifier according to any of the preceding claims, wherein: the Josephson parametric amplifier further includes, on the substrate, a ground plane that is configured by a superconductor and that is provided so as to sandwich the superconducting quantum interference device therebetween; and the ring-shaped structure is connected to the ground plane.

5. The Josephson parametric amplifier according to any of the preceding claims, wherein: the Josephson parametric amplifier further includes, on the substrate, a ground plane that is configured by a superconductor and that is provided so as to sandwich the superconducting quantum interference device therebetween; and the ring-shaped structure is connected to the ground plane via an insulator film.

6. The Josephson parametric amplifier according to any of the preceding claims , further including a pump signal generating portion that generates a pump signal for modulating non-linear inductance of the superconducting quantum interference device.

7. A method of manufacturing a Josephson parametric amplifier, the method including:
forming a superconducting quantum interference device that includes a Josephson junction on a substrate; forming a ring-shaped structure, which is configured by a superconductor, so as to cover the superconducting quantum interference device; and disposing a magnetic flux generating portion, which generates magnetic flux passing through a ring inner side of the ring-shaped structure, at a position aligned with the substrate.

8. The method of manufacturing a Josephson parametric amplifier according to claim 7, wherein the ring-shaped structure has an opening at a position that overlaps with the superconducting quantum interference device in plan view.

9. The method of manufacturing a Josephson parametric amplifier according to claim 7 or claim 8, wherein the ring-shaped structure includes a bridge structure that straddles the superconducting quantum interference device.
